# EUROPEAN PATENT SPECIFICATION

(11) **EP 4 207 252 B1**
(45) Date of publication and mention of the grant of the patent: **04.11.2026**
(21) Application number: 21893372.9
(22) Date of filing: 17.06.2021
(51) Int. Cl.: H10N 50/01, H10B 61/00

(54) **METHOD FOR ETCHING MRAM MAGNETIC TUNNEL JUNCTION**
ÄTZVERFAHREN FÜR EINEN MRAM-MAGNETTUNNELÜBERGANG
PROCÉDÉ DE GRAVURE DE JONCTION TUNNEL MAGNÉTIQUE MRAM

(30) Priority: 23.11.2020 CN 202011318813
(43) Date of publication of application: 05.07.2023
(73) Proprietor: Jiangsu Leuven Instruments Co. Ltd, Xuzhou, Jiangsu 221300 (CN)
(72) Inventor: LI, Jiahe, Xuzhou, Jiangsu 221300 (CN); YANG, Yuxin, Xuzhou, Jiangsu 221300 (CN); PENG, Taiyan, Xuzhou, Jiangsu 221300 (CN); XU, Kaidong, Xuzhou, Jiangsu 221300 (CN)
(74) Representative: dompatent
(86) International application number: PCT/CN2021/100599
(87) International publication number: WO 2022/105218

(56) References cited:
- CN-A- 106 676 532
- CN-A- 107 623 014
- CN-A- 111 162 005
- US-A1- 2005 051 820
- US-A1- 2013 146 997
- US-A1- 2017 125 668
- US-A1- 2018 033 957

## Description

### TECHNICAL FIELD

The present invention relates to the field of magnetic random access memory, and in particular to a method for etching an MRAM magnetic tunnel junction.

### BACKGROUND

At present, the widely used memory types are SRAM (Static Random Access Memory), DRAM (Dynamic Random Access Memory), Flash (Flash Memory) and the like. SRAM is capable of saving the data stored in it without refreshing the circuit, which has a relatively high performance but a low integration. DRAM has a high integration and a low power consumption, but it needs to refresh the circuit to continuously save data. MRAM (Magnetic Random Access Memory) has the high-speed reading and writing capability of SRAM and the high integration of DRAM, it can be written repeatedly for unlimited times basically, it can be used in systems that need both fast and huge amounts of data storage and data retention after power failure, and it can be recovered quickly. In terms of "nonvolatile" characteristic, only MRAM and FLASH have this function at present, while Flash lacks the "random access" function. This means that MRAM has a broader prospect, especially can play an important role in the fields of automobile, industry, military and space.

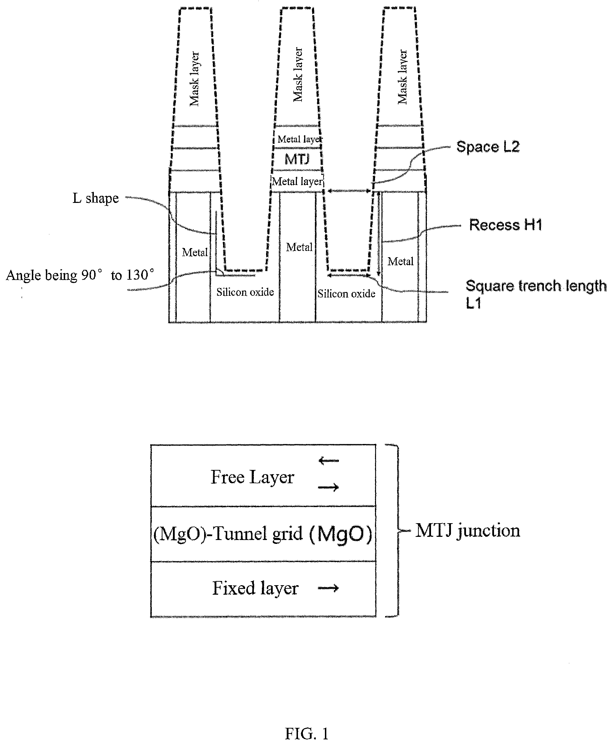

Unlike the traditional memory, MRAM stores data in the form of magnetic field polarization rather than charge. The MTJ junction that is the basic structure in the MRAM storage cell is as illustrated in FIG. 1. The uppermost layer is a free layer with a variable magnetic field polarization direction, the middle layer is a tunnel grid layer, and the lower layer is a fixed layer with a fixed magnetic field direction, which are collectively known as the MTJ junction (Magnetic Tunnel Junction). When the magnetic field direction of the free layer is parallel to that of the fixed layer, the storage cell presents a low resistance. When the magnetic field is in an opposite direction, it presents a high resistance. MRAM determines whether the stored data are 0 or 1 by detecting the resistance of the storage cell.

In the MRAM process, MTJ etching is an extremely critical step. The etching equipment mainly includes a reactive ion etching RIE (Reactive Ion Etching) and an ion beam etching IBE (Ion Beam Etching). RIE is a method of etching by a chemical reaction and a physical ion bombardment. IBE uses an ion beam with certain energy to bombard the material surface for etching, and the directionality is strong. At present, the RIE and IBE etching are the mainstream methods of MTJ etching. Either the IBE etching or the RIE etching, the following requirements need to be satisfied.
1. During etching, it is necessary to maintain the high profile of MTJ junction, which is beneficial to improve the performance and life of TMR (Tunnel Magnetoresistance Resistance).
2. The magnesium oxide layer in MTJ cannot have a sidewall contamination (Re-dep), otherwise it will cause a short circuit failure.
3. There is more residual hard mask (HM) and less residual deposition (Residue), which is beneficial to the subsequent process and improves the device survival rate.

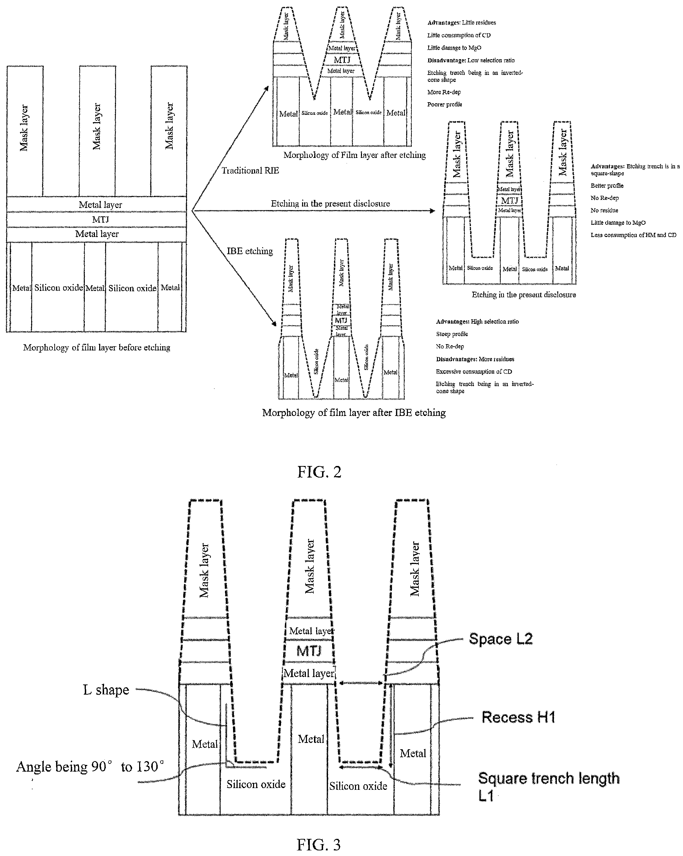

As illustrated in FIG. 2, the traditional IBE etching has a relatively high selectivity, but the magnesium oxide layer is damaged greatly and the residual deposition is relatively more. The selection ratio of the traditional RIE etching is too low and the profile is relatively poor. Therefore, it is difficult to satisfy the above three etching requirements at the same time.

In addition, with the reduction of the volume of the magnetic memory layer, the spin-polarized current required for writing or conversion operation is also smaller. Therefore, it is expected to make smaller and denser MTJ junction patterns to reduce the damage and shortening of MTJ memory device life caused by control. However, the smaller and denser MTJ junction, using the conventional IBE etching or RIE etching, is more difficult to satisfy the above three etching requirements..

US 2005/051820 A1 discloses a method of fabricating a magnetic tunnel junction (MTJ) device. A patterned hard mask is oxidized to form a surface oxide thereon. An MTJ stack is etched in alignment with the patterned hard mask after the oxidizing of the patterned hard mask. Etch selectivity between the hard mask and the MTJ stack is improved. Preferably, the MTJ stack etch (main RIE step) uses a Cl₂ and O₂ recipe, and a subsequent cleanup and stop layer etch uses a CF₄ and O₂ recipe, wherein a certain overetch into an underlying insulator may be performed.

### SUMMARY

The technical problems to be solved by the present invention is to provide a method for etching an MRAM magnetic tunnel according to claim 1. In the method for etching the MRAM magnetic tunnel, the traditional RIE can be combined with the traditional IBE, and by means of the arrangement of an etching sequence and the selection of etching parameters, the method is suitable for the etching of non-dense magnetic tunnel junctions, while the etching effect of the small-sized dense magnetic tunnel junctions is significantly improved.

In order to solve the above technical problems, the following technical solutions are adopted in the present disclosure.

Provided is a method for etching an MRAM magnetic tunnel junction. The method comprises the following steps.

In Step 1, a main etching step of the magnetic tunnel junction is performed: a main-etching-step etching with an etching amount of t1 is performed on the magnetic tunnel junction by using an ion beam etching and/or a reactive ion etching. A direction angle of an ion beam is 10° to 60°, and a bias voltage of the reactive ion etching is 400 V to 1000 V.

In Step 2, a cleaning step of the magnetic tunnel junction is performed: a cleaning-step etching with an etching amount of t2 is performed on the magnetic tunnel junction that the main etching step is completed, where t1:t2≥0.5. The cleaning-step etching includes a the reactive ion etching, wherein a mode of the reactive ion etching is a continuous mode or a pulse mode. A bias voltage of the reactive ion etching is 50 V to 400 V, and a pulse duty ratio is 5% to 50%. After the cleaning-step etching is completed, a morphology of a trench etched into a bottom electrode or a bottom dielectric layer is a quasi-square.

In Step 2, the cleaning-step etching can be performed in combination of an ion beam etching and the reactive ion etching, wherein a beam voltage of the ion beam etching is 50 V to 200 V

The method further may include Step 3 of an in-situ protection of the magnetic tunnel junction, a chemical vapor deposition method is adopted to grow a dielectric film layer around the magnetic tunnel junction after the cleaning-step etching is completed for the in-situ protection.

The etching amount t2 in the cleaning-step etching can be 5 nm to 100 nm.

In Step 1, the ion beam etching may include a large-angle ion beam etching and a small-angle ion beam etching.

The large-angle ion beam etching refers to the ion beam etching with a direction angle of 30° to 60°, the small-angle ion beam etching refers to the ion beam etching with a direction angle of 10° to 30°. When a time period of the large-angle ion beam etching is T1 and a time period of the small-angle ion beam etching is T2, T1 ≥ 1.5 T2.

In the main etching step and the cleaning step, when adopting the ion beam etching, the gas used in an ion beam chamber can be one or any combination of inert gas, nitrogen, oxygen, fluoro gas, amino gas, carbon monoxide, carbon dioxide and alcohol.

In the main etching step and the cleaning step, when adopting the reactive ion etching, a power of the ion source in the reaction ion chamber can be 50 W to 1000 W, a chamber pressure can be 0.066661185 Pa (0.5 mTorr) to 1.3332237 Pa (10 mTorr), a gas flow can be 10 sccm to 500 sccm, and the gas can be one or any combination of inert gas, nitrogen, oxygen, fluoro gas, amino gas, carbon monoxide, carbon dioxide and alcohol.

For example, a length of a lower bottom edge of the trench is L1, a length of an upper bottom edge of the trench is L2, a height of the trench is H1, and an included angle between the lower bottom edge and the side edge of the trench is α, and L1:L2=0.3 to 1.0, H1:L2=0.1 to 2.0, α=90° to 130°.

Provided is, in particular, the following method for etching the MRAM magnetic tunnel junction. The method includes the following steps.

In Step 1, the main etching step of the magnetic tunnel junction is performed: the main-etching-step etching with an etching amount of t1=35 nm is performed on the magnetic tunnel junction by using the ion beam etching. A method of the ion beam etching is introducing a magnetic tunnel junction sample into an ion beam etching chamber, the direction angle of the ion beam is selected as 25°, energy of the ion beam is 600 V, and a shielding gas is selected as argon. The magnetic tunnel junction sample includes a mask layer, a cap layer, a magnetic tunnel junction, a bottom electrode metal layer and a bottom dielectric layer from a top to a bottom. The bottom dielectric layer is equidistantly nested with metal lower electrodes with the same number as masks in the mask layer, and positions of the metal lower electrodes are in correspondence to the positions of the masks. The ion beam etching stops at the remaining 5 nm of the bottom electrode metal layer; the etching amount of the reactive ion etching is 35 nm.

In Step 2, the cleaning step of the magnetic tunnel junction is performed: the cleaning-step etching with the etching amount of t2=30 nm is performed on the magnetic tunnel junction after the main etching step is completed by using the reactive ion etching. The method of the reactive ion etching comprises transferring the magnetic tunnel junction sample after the ion beam etching is completed in Step 1 from the ion beam etching chamber to a reactive ion etching chamber through a vacuum transfer chamber to perform the reactive ion etching. Parameters for the reactive ion etching are: a reactive ion pulse duty ratio is selected as 20%, a power of the ion source is 700 W, a bias voltage is 400 V, a chamber pressure is 0.66661185 Pa (5 mTorr), and a flow rate of argon is 100 sccm; the etching amount of the reactive ion etching is 30 nm. After the cleaning-step etching is completed, a morphology of a trench etched into a bottom electrode or a bottom dielectric layer is a quasi-square.

In Step 3, the in-situ protection of the magnetic tunnel junction is performed: the magnetic tunnel junction sample after the cleaning-step etching is completed is introduced into a plasma enhanced chemical vapor deposition chamber through a vacuum transferring chamber, and a SiN film with 35 nm is deposited for the in-situ protection.

The present invention has the following beneficial effects: RIE can be combined with IBE, and by means of the arrangement of an etching sequence and the selection of etching parameters, the method is suitable for the etching of non-dense magnetic tunnel junctions, while the etching effect of small-sized dense magnetic tunnel junctions is significantly improved. Therefore, the problems of the selection ratio and the profile during dense pattern etching being low are solved. Furthermore, a trench is etched to be of a quasi-square morphology, such that the TMR of an MTJ junction can be substantially improved, the service life thereof can be substantially prolonged, and bottom depositions can be eliminated.

### BRIEF DESCRIPTION OF THE DRAWINGS

FIG. 1 illustrates a schematic diagram of a magnetic tunnel junction.
FIG. 2 illustrates a comparison between the etching effect of the present invention and that of the traditional RIE etching or the traditional IBE etching. The etching stops on the medium SiO.
FIG. 3 illustrates a schematic diagram of a morphology of the sample film layer after etching of the present invention.
FIG. 4 illustrates the comparison between the etching effect of the present invention and that of the traditional RIE etching or the traditional IBE etching. The etching stops on the bottom electrode metal.

### DETAILED DESCRIPTION OF THE EMBODIMENTS

The present disclosure will be clearly and completely described below with reference to the accompanying drawings and the specific preferred embodiments.

In the description of the present disclosure, it is necessary to understand that the orientation or position relationship indicated by the terms "left", "right", "upper", "lower" and the like is based on the orientation or position relationship as illustrated in the accompanying drawings, which is only for the convenience of describing the present disclosure and simplifying the description, rather than indicating or implying that the device or element referred to must have a specific orientation, be constructed and operated in a specific orientation. "First" "Second" and the like do not indicate the importance of the parts, so it cannot be understood as restrictions on the present disclosure. The specific dimensions used in this embodiment are only for illustration of the technical solutions, and do not limit the protection scope of the present disclosure.

As illustrated in FIG. 1, a method for etching an MRAM magnetic tunnel junction comprises the following steps.

In Step 1, a main etching step is performed: an reactive ion etching (RIE) or an ion beam etching (IBE) is performed.

A wafer is introduced into the corresponding reaction chamber, and the primary etching is performed on the magnetic tunnel junction sample to be etched.

As illustrated in FIG. 2, the magnetic tunnel junction sample to be etched includes a mask layer, a metal layer (also called as a cap layer or a cover layer), a MTJ junction, a metal layer (also called as a seed layer) and a bottom dielectric layer from the top to the bottom.

The mask layer includes a plurality of masks evenly spaced on the cap layer. The bottom dielectric layer is equidistant nested with the bottom electrodes with the same number as the mask, and the positions of the bottom electrodes are in correspondence to the positions of the masks. Further, the bottom dielectric layer is preferably silicon oxide and the like.

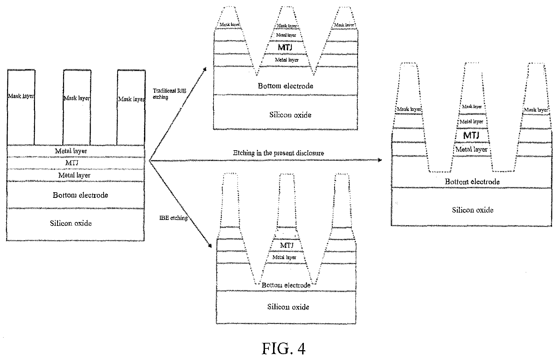

As illustrated in FIG. 4, the magnetic tunnel junction sample to be etched includes a mask layer, a metal layer (also called as a cap layer or a cover layer), a MTJ junction, a metal layer (also called as a seed layer), a bottom electrode and a bottom dielectric layer from the top to the bottom. The arrangement of the mask in the mask layer is the same as that in FIG. 2. The bottom dielectric layer is preferably silicon oxide and the like.

The process conditions of ion beam etching IBE are preferably as follows: a direction angle of the ion beam is preferably 10° to 60° (the included angle between the ion beam and the normal line of the wafer), energy is preferably 200 V to 1000 V, a shielding gas is preferably one or various combinations of inert gas, nitrogen, oxygen, fluoro gas, amino gas, carbon monoxide, carbon dioxide, alcohol and the like, and further preferably the inert gases such as argon, krypton, and xenon.

The process conditions of reactive ion etching RIE are preferably as follows: a power of the ion source is 50 W to 1000 W, a chamber pressure is 0.066661185 Pa (0.5 mTorr) to 3.99965976 Pa (30 mTorr), a gas flow is 10 sccm to 500 sccm, and the gas is one or any combination of inert gas, nitrogen, oxygen, fluoro gas, amino gas, carbon monoxide, carbon dioxide and alcohol.

In Step 1, an etching amount of the main etching step is t1.

In Step 1, an ion beam etching (IBE) or a reactive ion etching(RIE) is adopted, which preferably has the following beneficial effects.
1. The selection of the direction angle of the ion beam can effectively guarantee the profile of the primary etching and reduce the consumption of CD (the size of magnesium oxide layer in the MTJ junction). RIE main etching can rapidly implement the etching of metal layer, and has less damage to the sidewall of magnesium oxide layer.
   In the IBE etching process of the embodiments of the present disclosure, a variable direction angle is preferably adopted for the ion beam, the ion beam etching includes a large-angle ion beam etching and a small-angle ion beam etching. The large-angle ion beam etching is commonly referred to the ion beam etching with a direction angle of 30° to 60°, the small-angle ion beam etching is commonly referred to the ion beam etching with a direction angle of 10° to 30°. When a time period of the large-angle ion beam etching is T1 and a time period of the small-angle ion beam etching is T2, preferably T1 ≥ 1.5 T2.
2. The inert gas etching is adopted in the present disclosure, which can obtain a relative high profile and a clean sidewall.
3. The access amount and the profile can be increased, by increasing the proportion of the etching amount t1 in the main etching step.

In Step 2, a cleaning step is performed: the magnetic tunnel junction sample after the main etching step is completed in Step 1 is transferred to the corresponding cleaning step chamber through the vacuum chamber, and the secondary etching of the cleaning step is carried out in the cleaning-step chamber.

There are the following two preferred embodiments in the cleaning-step etching.

The first embodiment is a continuous mode or a pulse mode of the reactive ion etching.

The second embodiment is a continuous mode or a pulse mode of the reactive ion etching, and a low-energy ion beam etching.

The process conditions of reactive ion etching RIE are preferably as follows: an reactive ion pulse Pulsing is preferably 5% to 50%, an ion source power Source is 50 W to 1000 W, a bias voltage is 10 V to 1000 V, a chamber pressure is 0.066661185 Pa (0.5 mTorr) to 1.3332237 Pa (10 mTorr), a gas flow is 10 sccm to 500 sccm, and one or any combination of inert gas, nitrogen, oxygen, fluoro gas, amino gas, carbon monoxide, carbon dioxide, alcohol and the like is used, and the inert gas such as argon or oxygen-containing gas is further preferred.

The process conditions of ion beam etching IBE are preferably as follows: the direction angle is preferably 30° to 60° (the included angle between the ion beam and the normal line of the wafer), the energy is preferably 50 V to 200 V, and one or various combinations of inert gas, nitrogen, oxygen, fluoro gas, amino gas, carbon monoxide, carbon dioxide, alcohol and the like are preferred as the shielding gas, and inert gases such as argon, krypton, and xenon are further preferred.

In Step 2, the etching amount of cleaning step is t2, the value of t2 is preferably 5 nm to 40 nm, t1:t2≥0.5. The etching amount ratio of the two-time etching is preferably t1:t2=1.5 to 4.0.

After the secondary etching is completed, the etching morphology on the bottom electrode and/or bottom dielectric layer is a square trench as illustrated in FIG. 3 and FIG. 4.

Provided is a etching trench of the MRAM magnetic tunnel junction located at the bottom. The trench is the etching morphology located on the bottom electrode or the bottom dielectric layer, and the shape is a quasi-square. As illustrated in FIG. 2, the trench is located on the bottom medium layer. As illustrated in FIG. 4, the directional trench is located in the bottom electrode. As an alternative, the trench can also be located in both the bottom electrode and/or the bottom dielectric layer in FIG. 4.

The length of the lower bottom edge of the trench (corresponding to the trench length in FIG. 3) is L1, the length of the upper bottom edge of the trench (corresponding to the Space in FIG. 3) is L2, the height of the trench (corresponding to the Recess in FIG. 3) is H1, and the included angle between the lower bottom edge and the side edge of the trench is α; Then: α=90° to 130°, that is, the trench is approximately L-shaped, thus forming a quasi-square, preferably L1:L2=0.3 to 1.0, H1:L2=0.1 to 2.0.

Because of the factors such as the charge accumulation effect and the selection ratio, a small-size dense pattern is more difficult to form a quasi-square etching trench than a conventional pattern. When *fterthe present invention is adopted, the obvious quasi-square trench characteristic can still be etched in the case where the pattern density reaches 80 nm to 100 nm at pitch.

In step 2, the low-energy ion beam etching or the continuous mode or pulse mode of the reactive ion etching is adopted, which preferably has the following beneficial effects.
1. The low-energy and low-pressure conditions can improve the ability to remove sediment contamination, and ensure that no sidewall contamination will occur under the appropriate process window.
2. The low energy can reduce the damage to the sidewall of the magnesium oxide layer.
3. The inert gas etching such as argon can also obtain a higher profile and a cleaner sidewall. When oxygen-containing gas etching is adopted, the sidewall can be oxidized. When reactive gas etching is adopted, the selection ratio can be increased.
4. The profile of the main etching step is retained, and the final profile is 75° to 90°. Even if the center distance between the two cells is pitch≤100 nm, the final profile can also reach greater than 85°.
5. Compared with the traditional single etching method, the selection ratio is greatly improved.
6. A quasi-square etching trench can be formed at the bottom. The bottom of the trench is flat, and there is no or less deposition contamination. The etching trench can be formed in the dielectric layer or the lower electrode layer. The corners at the bottom of the trench can be in the shape of "L". After etching the coating film, the film layer still has an obvious "L" shape.
7. An angle of the obtained trench is 90° to 130°, and the length of the bottom edge L1 of the trench is 0.5 to 1.0 times of the length of the bottom edge L2 of the trench. When the Recess: Space is 0.5 to 2 and the aspect ratio (total height: Space) is 1.0 to 5.0, a relative good trench shape can be achieved.

In Step 3, the film coating is performed: the etched magnetic tunnel junction sample is coated with film. The coating film layer is silicon nitride, silicon oxide or a combination of the two. The thickness of the coating film is 10 nm to 100 nm, and the temperature of the coating film is 150 °C to 350 °C. The in-situ protective film can prevent the metal lamination of MTJ from being corroded by water vapor in the air, causing in a short circuit of the device.

The present disclosure adopts the following two specific preferred embodiments of the invention for further detailed description.

### Example 1

In Step 1, reactive ion etching is used for the main etching step. The magnetic tunnel junction sample as illustrated in FIG. 2 is introduced into the RIE chamber for the main etching. The energy of the main etching step is that: the source power is 500 W, the bias voltage is 600 W, the chamber pressure is 2.66643984 Pa ( 20 mTorr), and an etching gas is Kr.

Reactive ion etching is stopped at the depth from the remaining 10 nm of the lowest metal layer to 40 nm of the bottom dielectric layer. In Example 1, the primary etching is preferably stopped at the depth of the remaining 5 nm of the lowest metal layer, and the etching amount is t1, which is preferably 35 nm.

In Step 2, the combination of reactive ion etching RIE and ion beam etching IBE is used for the cleaning step.

In Step 21, the reactive ion etching RIE: the secondary reactive ion etching is performed on the magnetic tunnel junction sample that the main etching step in Step 1 is completed through a vacuum chamber. The parameters for the secondary reactive ion etching are that: the ion source power is 700 W, the bias voltage is 400 V, the cavity pressure is 0.66661185 Pa (5 mTorr), the flow rate of argon is 100 sccm.

In Step 22, the ion beam etching: the magnetic tunnel junction sample that the secondary reactive ion etching is completed in Step 21 is transferred from RIE to IBE through the vacuum chamber for the ion beam etching. The ion beam etching process conditions are preferably as follows: BMV is 100V, the incident angle is 60°, and the etching gas is Ar. The etching depth, i.e. ion beam etching amount t2=30 nm. After the secondary etching is completed, the etching morphology on the bottom dielectric layer is a quasi-square trench.

In Step 3, the film coating is performed: the sample after the ion beam etching is introduced into the plasma enhanced chemical vapor deposition chamber through the vacuum transferring chamber, and the SiN film with 30 nm is deposited for the in-situ protection.

The length of the lower bottom edge of the trench (corresponding to the trench length in FIG. 3) obtained in this example is L1, the length of the upper bottom edge of the trench (corresponding to the Space in FIG. 3) is L2, the height of the trench (corresponding to the Recess in FIG. 3) is H1, and the included angle between the lower bottom edge and the side edge of the trench is α; Then: α= 120°, that is, the trench is approximately L-shaped, thus forming a quasi-square, L1:L2=0.5, H1:L2=0.5.

### Example 2

In Step 1, the reactive ion etching is used for the main etching step: the magnetic tunnel junction sample as illustrated in FIG. 4 is introduced into the reactive ion chamber, the ion source power of the reactive ion etching is 600 W, the bias voltage is 600 V, the chamber pressure is 1.3332237 Pa (10 mTorr), and the flow rate of argon is 150 sccm. The magnetic tunnel junction sample to be etched includes the mask layer, the cap layer, the MTJ junction, the bottom electrode layer and the bottom dielectric layer from the top to the bottom. The reactive ion etching is stopped at 3 nm where the bottom electrode layer consumes. At this time, the etching amount of reactive ion etching is 20 nm.

In Step 2, the reactive ion etching is used for the cleaning step. The secondary etching process conditions are preferably as follows: the reactive ion pulse Pulsing is selected as 5%, the reactive ion source power Source is 300 W, the bias voltage is 600 V, the chamber pressure is 0.19998299 Pa (1.5 mTorr), the flow rate of argon is 200 sccm, the etching is conducted at the height of 30 nm to the seed layer, that is, the etching amount of the reactive ion etching is t2= 15 nm. After the secondary etching is completed, the etching morphology on the bottom electrode is the quasi-square trench.

In Step 2A, the ion beam cleaning is performed. The secondary etching sample is transferred to the IBE chamber through the vacuum chamber, an angle of the ion beam is selected as 45°, the energy of the ion beam is 100 V, and the argon gas is used for etching, the etching depth remaining on the bottom electrode layer is 3 nm. The morphology comparison is as illustrated in FIG. 4.

In Step 3, the in-situ protection of the magnetic tunnel junction is performed: the magnetic tunnel junction sample after the ion beam cleaning is completed is introduced into the plasma enhanced chemical vapor deposition chamber through the vacuum transferring chamber, and a SiN film with 10 nm is deposited for the in-situ protection.

The length of the bottom edge of the trench of the sample obtained in this example (corresponding to the trench length in FIG. 3) is L1, the length of the top edge of the trench (corresponding to the Space in FIG. 3) is L2, the height of the trench (corresponding to the Recess in FIG. 3) is H1, and the included angle between the bottom edge and the side edge of the trench is α; Then: α=110°, that is, approximately an L-shaped trench results, thus forming a quasi-square, L1:L2=0.6, H1:L2=0.8.

### Example 3

In Step 1, the ion beam etching is used for the main etching step: the magnetic tunnel junction sample is introduced into the ion beam etching chamber, the direction angle of the ion beam is selected as 25°, the energy is 600 V, and the shielding gas is selected as argon for etching. The magnetic tunnel junction samples include the mask layer, the cap layer, the MTJ junction, the bottom electrode metal layer and the bottom dielectric layer from the top to the bottom. The bottom dielectric layer is equidistant nested with metal lower electrodes with the same number as the masks in the mask layer, and the positions of metal lower electrodes are in correspondence to the positions of the masks. The ion beam etching is stopped at the remaining 5 nm of the lowest metal layer, that is, the etching amount of the ion beam t1 is 35 nm.

In step 2, the reactive ion etching is used for cleaning: the magnetic tunnel junction sample that the ion beam etching is completed in Step 1 is transferred from the ion beam etching chamber to the reactive ion etching chamber through the vacuum chamber for the secondary etching. The parameters for secondary etching are that: the reactive ion pulse is selected as 20%, the ion source power is 700 W, the bias voltage is 400 V, the chamber pressure is 0.66661185 Pa (5 mTorr), the flow rate of argon is 100 sccm, and the etching amount of the reactive ion etching t2=30 nm. After the secondary etching is completed, the etching morphology on the bottom dielectric layer is the quasi-square trench.

In Step 3, the film coating is performed: the sample after the secondary etching is introduced into the plasma enhanced chemical vapor deposition chamber through the vacuum transferring chamber, and the SiN film with 35 nm is deposited for the in-situ protection.

The length of the bottom edge of the trench of the sample obtained in this example (corresponding to the trench length in FIG. 3) is L1, the length of the top edge of the trench (corresponding to the Space in FIG. 3) is L2, the height of the trench (corresponding to the Recess in FIG. 3) is H1, and the included angle between the bottom edge and the side edge of the trench is α; Then: α = 100°, that is, the trench is approximately L-shaped, thus forming a quasi-square, L1:L2=0.8, H1:L2=1.0.

### Example 4

In Step 1, the reactive ion etching is used for the main etching step. The magnetic tunnel junction sample as illustrated in FIG. 2 is introduced into the RIE chamber for the main etching. The energy of the main etching step is the source power of 700 W, the bias power is 400 W, the chamber pressure is 1.99982988Pa (15 mTorr), the chamber pressure is 1.3332237 Pa (10 mTorr), and the etching gas is ethanol.

Reactive ion etching is stopped at the depth from the remaining 5 nm of the lowest metal layer to 40 nm of the bottom dielectric layer. In this example, the primary etching is preferably stopped at the interface between the metal and the medium, and the etching amount is t1, which is preferably 20 nm.

In Step 2, the reactive ion etching is used for the cleaning step. The secondary etching is continued in the reactive ion etching chamber. The secondary etching process conditions are preferably as follows: the reactive ion pulse Pulsing is selected as 30% , the reactive ion source power Source is 300 W, the bias voltage is 100 V, the chamber pressure is 0.66661185 Pa (5 mTorr), the flow rate of argon is 200 sccm, the etching is conducted at the height of 30 nm to the seed layer, that is, the etching amount is t2= 15 nm. After the secondary etching, the etching morphology on the bottom electrode is the quasi-square trench.

In Step 3, the film coating is performed. The sample after the secondary etching is introduced into the plasma enhanced chemical vapor deposition chamber through the vacuum transferring chamber, and the SiN film with 25 nm is deposited for the in-situ protection.

The length of the bottom edge of the trench of the sample obtained in this example (corresponding to the trench length in FIG. 3) is L1, the length of the top edge of the trench (corresponding to the Space in FIG. 3) is L2, the height of the trench (corresponding to the Recess in FIG. 3) is H1, and the included angle between the bottom edge and the side edge of the trench is α; Then: α = 95°, that is, the trench is approximately L-shaped, thus forming a quasi-square, L1:L2=1.0, H1:L2=1.5.

The preferred embodiments of the present invention are described in detail above. However, the present invention is not limited to the specific details of the above embodiments. Within the scope of the technical concept of the present invention, various equivalent transformations can be made for the technical solutions of the present invention, which are all within the protection scope of the present invention which is defined by the following claims.

## Claims

1. A method for etching an MRAM magnetic tunnel junction, comprising:
Step 1, a main etching step of the magnetic tunnel junction: performing a main-etching-step etching with an etching amount of t1 on the magnetic tunnel junction by using an ion beam etching, wherein a direction angle of an ion beam is 10° to 60°, and/or a reactive ion etching, wherein a bias voltage is 400 V to 1000 V; and
Step 2, a cleaning step of the magnetic tunnel junction: performing a cleaning-step etching with an etching amount of t2 on the magnetic tunnel junction after the main etching step is completed, wherein t1:t2≥0.5 and the cleaning-step etching includes a reactive ion etching in a continuous mode or a pulse mode, wherein a bias voltage is 50 V to 400 V, a pulse duty ratio is 5% to 50%, and, after the cleaning-step etching is completed, a morphology of a trench etched into a bottom electrode or a bottom dielectric layer is a quasi-square.

2. The method for etching the MRAM magnetic tunnel junction according to claim 1, wherein in Step 2, the cleaning-step etching is performed in combination of an ion beam etching and the reactive ion etching, wherein a beam voltage of the ion beam etching is 50 V to 200 V.

3. The method for etching the MRAM magnetic tunnel junction according to claim 1, wherein the method further includes Step 3 of an in-situ protection of the magnetic tunnel junction, wherein a chemical vapor deposition method is adopted to grow a dielectric film layer around the magnetic tunnel junction after the cleaning-step etching is completed for the in-situ protection.

4. The method for etching the MRAM magnetic tunnel junction according to claim 1, wherein the etching amount t2 in the cleaning-step etching is 5 nm to 100 nm.

5. The method for etching the MRAM magnetic tunnel junction according to claim 1, wherein in Step 1, the ion beam etching includes a large-angle ion beam etching and a small-angle ion beam etching.

6. The method for etching the MRAM magnetic tunnel junction according to claim 5, wherein the large-angle ion beam etching refers to the ion beam etching with a direction angle of 30° to 60°, the small-angle ion beam etching refers to the ion beam etching with a direction angle of 10° to 30°, and, when a time period of the large-angle ion beam etching is T1 and a time period of the small-angle ion beam etching is T2, T1≥1.5 T2.

7. The method for etching the MRAM magnetic tunnel junction according to claim 1 or 2, wherein in the main etching step and the cleaning step, when adopting the ion beam etching, the gas used in an ion beam chamber is one or any combination of inert gas, nitrogen, oxygen, fluoro gas, amino gas, carbon monoxide, carbon dioxide and alcohol.

8. The method for etching the MRAM magnetic tunnel junction according to claim 1 or 2 wherein in the main etching step and the cleaning step, when adopting the reactive ion etching, a power of the ion source in the reaction ion chamber is 50 W to 1000 W, a chamber pressure is 0,066661185 Pa (0.5 mTorr) to 1,3332237 Pa (10 mTorr), a gas flow is 10 sccm to 500 sccm, and the gas is one or any combination of inert gas, nitrogen, oxygen, fluoro gas, amino gas, carbon monoxide, carbon dioxide and alcohol.

9. The method for etching the MRAM magnetic tunnel junction according to claim 1, wherein a length of a lower bottom edge of the trench is L1, a length of an upper bottom edge of the trench is L2, a height of the trench is H1, an included angle between the lower bottom edge and a side edge of the trench is α, L1:L2=0.3 to 1.0, H1:L2=0.1 to 2.0, and α=90° to 130°.

10. The method for etching the MRAM magnetic tunnel junction according to claim 1, wherein the method comprises following steps:
Step 1, the main etching step of the magnetic tunnel junction: performing the main-etching-step etching with the etching amount of t1=35 nm on the magnetic tunnel junction by using the ion beam etching, wherein a method of the ion beam etching comprises introducing a magnetic tunnel junction sample into an ion beam etching chamber, wherein the direction angle of the ion beam is selected as 25°, energy of the ion beam is 600 V, and a shielding gas is selected as argon; the magnetic tunnel junction sample includes a mask layer, a cap layer, a magnetic tunnel junction, a bottom electrode metal layer and a bottom dielectric layer from a top to a bottom; the bottom dielectric layer is equidistantly nested with metal lower electrodes with a same number as masks in the mask layer, and positions of the metal lower electrodes are in correspondence to positions of the masks; and the ion beam etching stops at a remaining 5 nm of the bottom electrode metal layer;
Step 2, the cleaning step of the magnetic tunnel junction: performing the cleaning-step etching with the etching amount of t2=30 nm on the magnetic tunnel junction after the main etching step is completed by using the reactive ion etching, wherein a method of the reactive ion etching comprises transferring the magnetic tunnel junction sample after the ion beam etching is completed in Step 1 from the ion beam etching chamber through a vacuum transfer chamber to a reactive ion etching chamber to perform the reactive ion etching, wherein parameters for the reactive ion etching are that: a reactive ion pulse duty ratio is selected as 20%, a power of the ion source is 700 W, a bias voltage is 400 V, a chamber pressure is 0,66661185 Pa (5 mTorr), and a flow rate of argon is 100 sccm; and
Step 3, an in-situ protection of the magnetic tunnel junction: introducing the magnetic tunnel junction sample after the cleaning-step etching is completed through a vacuum transfer chamber into a plasma enhanced chemical vapor deposition chamber, and depositing a SiN film with 35 nm thickness for the in-situ protection.

## Patentansprüche

1. Verfahren zum Ätzen eines magnetischen Tunnelkontakts eines MRAM, umfassend:
Schritt 1, ein Hauptätzschritt des magnetischen Tunnelkontakts: Durchführen eines Hauptätzschritt-Ätzens mit einem Ätzbetrag von t1 am magnetischen Tunnelkontakt unter Verwendung von Ionenstrahlätzen, wobei ein Richtungswinkel des Ionenstrahls 10° bis 60° beträgt, und/oder von reaktivem Ionenätzen, wobei eine Vorspannung 400 V bis 1000 V beträgt; und
Schritt 2, ein Reinigungsschritt des magnetischen Tunnelkontakt: Durchführen eines Reinigungsschritt-Ätzens mit einem Ätzbetrag von t2 am magnetischen Tunnelkontakt, nachdem der Hauptätzschritt abgeschlossen ist, wobei t1:t2≥0,5; und das Reinigungsschritt-Ätzen ein reaktives Ionenätzen im kontinuierlichen Modus oder in einem Pulsmodus umfasst, wobei eine Vorspannung 50 V bis 400 V beträgt, ein Puls-Tastverhältnis 5 % bis 50 % beträgt und nach Abschluss des Reinigungsschritt-Ätzens eine Morphologie eines in eine Bodenelektrode oder eine untere dielektrische Schicht geätzten Grabens quasi quadratisch ist.

2. Verfahren zum Ätzen des magnetischen Tunnelkontakts eines MRAM nach Anspruch 1, wobei in Schritt 2 das Reinigungsschritt-Ätzen in Kombination aus Ionenstrahlätzen und reaktivem Ionenätzen durchgeführt wird, wobei eine Strahlspannung beim Ionenstrahlätzen 50 V bis 200 V beträgt.

3. Verfahren zum Ätzen des magnetischen Tunnelkontakts eines MRAM nach Anspruch 1, wobei das Verfahren ferner Schritt 3 eines In-situ-Schutzes des magnetischen Tunnelkontakts umfasst, wobei ein chemisches Gasphasenabscheidungsverfahren angewendet wird, um nach Abschluss des Reinigungsschritt-Ätzens für den In-situ-Schutz eine dielektrische Filmschicht um den magnetischen Tunnelkontakt herum aufzubauen.

4. Verfahren zum Ätzen des magnetischen Tunnelkontakts eines MRAM nach Anspruch 1, wobei der Ätzbetrag t2 beim Reinigungsschritt-Ätzen 5 nm bis 100 nm beträgt.

5. Verfahren zum Ätzen des magnetischen Tunnelkontakts eines MRAM nach Anspruch 1, wobei in Schritt 1 das Ionenstrahlätzen ein Großwinkel-Ionenstrahlätzen und ein Kleinwinkel-Ionenstrahlätzen umfasst.

6. Verfahren zum Ätzen des magnetischen Tunnelkontakts eines MRAM nach Anspruch 5, wobei sich das Großwinkel-Ionenstrahlätzen auf das Ionenstrahlätzen mit einem Richtungswinkel von 30° bis 60° bezieht, das Kleinwinkel-Ionenstrahlätzen sich auf das Ionenstrahlätzen mit einem Richtungswinkel von 10° bis 30° bezieht, und, wenn eine Zeitdauer des Großwinkel-Ionenstrahlätzens T1 ist und eine Zeitdauer des Kleinwinkel-Ionenstrahlätzens T2 ist, gilt T1≥1,5 T2.

7. Verfahren zum Ätzen des magnetischen Tunnelkontakts eines MRAM nach Anspruch 1 oder 2, wobei im Hauptätzschritt und im Reinigungsschritt bei Anwendung des Ionenstrahlätzens das in einer Ionenstrahlkammer verwendete Gas aus einem oder einer beliebigen Kombination aus Inertgas, Stickstoff, Sauerstoff, Fluorgas, Aminogas, Kohlenmonoxid, Kohlendioxid und Alkohol besteht.

8. Verfahren zum Ätzen des magnetischen Tunnelkontakts eines MRAM nach Anspruch 1 oder 2, wobei im Hauptätzschritt und im Reinigungsschritt bei Anwendung des reaktiven Ionenstrahlätzens eine Leistung der Ionenquelle in der Reaktionsionenkammer 50 W bis 1000 W beträgt, ein Kammerdruck 0,066661185 Pa (0,5 mTorr) bis 1,3332237 Pa (10 mTorr) beträgt, ein Gasdurchfluss 10 sccm bis 500 sccm beträgt und das Gas aus einem oder einer beliebigen Kombination aus Inertgas, Stickstoff, Sauerstoff, Fluorgas, Aminogas, Kohlenmonoxid, Kohlendioxid und Alkohol besteht.

9. Verfahren zum Ätzen des magnetischen Tunnelkontakts eines MRAM nach Anspruch 1, wobei eine Länge einer unteren Bodenkante des Grabens L1 ist, eine Länge einer oberen Bodenkante des Grabens L2 ist, eine Höhe des Grabens H1 ist, ein eingeschlossener Winkel zwischen der unteren Bodenkante und einer Seitenkante des Grabens α ist, wobei L1:L2=0,3 bis 1,0, H1:L2 = 0,1 bis 2,0 und α = 90° bis 130° gilt.

10. Verfahren zum Ätzen des magnetischen Tunnelkontakts eines MRAM nach Anspruch 1, wobei das Verfahren die folgenden Schritte umfasst:
Schritt 1, der Hauptätzschritt des magnetischen Tunnelkontakts: Durchführen des Hauptätzschritt-Ätzens mit einem Ätzbetrag von t1=35 nm am magnetischen Tunnelkontakt mittels Ionenstrahlätzens, wobei ein Verfahren des Ionenstrahlätzens das Einbringen einer Probe eines magnetischen Tunnelkontakts in eine Ionenstrahlätzkammer umfasst, wobei der Richtungswinkel des Ionenstrahls als 25° gewählt wird, die Energie des Ionenstrahls 600 V beträgt, und als Schutzgas Argon gewählt wird; wobei die Probe des magnetischen Tunnelkontakts von oben nach unten eine Maskenschicht, eine Deckschicht, einen magnetischen Tunnelkontakt, eine untere Elektrodenmetallschicht und eine untere dielektrische Schicht aufweist; wobei die untere dielektrische Schicht in gleichen Abständen mit unteren Metallelektroden verschachtelt ist, deren Anzahl der Anzahl der Masken in der Maskenschicht entspricht, und die Positionen der unteren Metallelektroden den Positionen der Masken entsprechen; und wobei das Ionenstrahlätzen bei einer Restdicke von 5 nm der unteren Elektrodenmetallschicht stoppt;
Schritt 2, der Reinigungsschritt des magnetischen Tunnelkontakts: Durchführen des Reinigungsschritt-Ätzens mit einem Ätzbetrag von t2=30 nm am magnetischen Tunnelkontakt nach Abschluss des Hauptätzschritts mittels reaktivem Ionenätzens, wobei ein Verfahren des reaktiven Ionenätzens umfasst, dass die Probe des magnetischen Tunnelkontakts nach Abschluss des Ionenstrahlätzens in Schritt 1 aus der Ionenstrahlätzkammer durch eine Vakuumtransferkammer in eine reaktive Ionenätzkammer überführt wird, um das reaktive Ionenätzen durchzuführen, wobei die Parameter für das reaktive Ionenätzen wie folgt sind: ein als 20 % gewähltes reaktives Ionen-Puls-Tastverhältnis, eine Leistung der Ionenquelle von 700 W, eine Vorspannung von 400 V, ein Kammerdruck von 0,66661185 Pa (5 mTorr) und eine Argon-Durchflussrate von 100 sccm; und
Schritt 3, ein In-situ-Schutz des magnetischen Tunnelkontakts: Einbringen der Probe des magnetischen Tunnelkontakts nach Abschluss des Reinigungsschritt-Ätzens über eine Vakuumtransferkammer in eine Kammer zur plasmaunterstützten chemischen Gasphasenabscheidung, und Abscheiden einer 35 nm dicken SiN-Schicht für den In-situ-Schutz.

## Revendications

1. Procédé de gravure d'une jonction de tunnel magnétique MRAM, comprenant :
étape 1, une étape de gravure principale de la jonction de tunnel magnétique consistant à :
effectuer une gravure d'étape de gravure principale avec une quantité de gravure de t1 sur la jonction de tunnel magnétique au moyen d'une gravure par faisceau d'ions, dans lequel un angle de direction d'un faisceau d'ions est compris entre 10° et 60°, et/ou une gravure ionique réactive, dans lequel une tension de polarisation est comprise entre 400 V et 1000 V ; et
étape 2, une étape de nettoyage de la jonction de tunnel magnétique consistant à :
effectuer une gravure d'étape de nettoyage avec une quantité de gravure de t2 sur la jonction de tunnel magnétique après l'exécution de l'étape de gravure principale, dans lequel t1:t2 ≥ 0,5, et la gravure d'étape de nettoyage comprend une gravure ionique réactive dans un mode continu ou dans un mode pulsé, dans lequel la tension de polarisation est comprise entre 50 V et 400 V, un rapport cyclique des impulsions est compris entre 5 % et 50 % et, après l'exécution de la gravure d'étape de nettoyage, une morphologie d'une tranchée gravée dans une électrode inférieure ou dans une couche diélectrique inférieure est quasiment carrée.

2. Procédé de gravure de la jonction de tunnel magnétique MRAM selon la revendication 1, dans lequel, à l'étape 2, la gravure d'étape de nettoyage est effectuée par combinaison d'une gravure par faisceau d'ions et de la gravure ionique réactive, dans lequel une tension de faisceau de la gravure par faisceau d'ions est comprise entre 50 V et 200 V.

3. Procédé de gravure de la jonction de tunnel magnétique MRAM selon la revendication 1, dans lequel le procédé comprend en outre une étape 3 consistant à protéger in-situ la jonction de tunnel magnétique, dans lequel un procédé de dépôt chimique en phase vapeur est adopté pour développer une couche de film diélectrique autour de la jonction de tunnel magnétique après l'exécution de la gravure d'étape de nettoyage à des fins de la protection in-situ.

4. Procédé de gravure de la jonction de tunnel magnétique MRAM selon la revendication 1, dans lequel la quantité de gravure t2 de la gravure d'étape de nettoyage est comprise entre 5 nm et 100 nm.

5. Procédé de gravure de la jonction de tunnel magnétique MRAM selon la revendication 1, dans lequel, à l'étape 1, la gravure par faisceau d'ions fait appel à une gravure par faisceau d'ions avec un grand angle et à une gravure par faisceau d'ions avec un petit angle.

6. Procédé de gravure de la jonction de tunnel magnétique MRAM selon la revendication 5, dans lequel la gravure par faisceau d'ions avec un grand angle se rapporte à la gravure par faisceau d'ions avec un angle de direction compris entre 30° et 60°, la gravure par faisceau d'ions avec un petit angle se rapporte à la gravure par faisceau d'ions avec un angle de direction compris entre 10° et 30°, et
lorsqu'une période de temps de la gravure par faisceau d'ions avec un grand angle est T1 et qu'une période de temps de la gravure par faisceau d'ions avec un petit angle est T2, T1 ≥ 1,5 T2.

7. Procédé de gravure de la jonction de tunnel magnétique MRAM selon la revendication 1 ou la revendication 2, dans lequel, à l'étape de gravure principale et à l'étape de nettoyage, lors de l'adoption de la gravure par faisceau d'ions, le gaz utilisé dans une chambre de faisceau d'ions est l'un ou une combinaison quelconque d'un gaz inerte, d'azote, d'oxygène, d'un gaz fluoré, d'un gaz traité aux amines, de monoxyde de carbone, de dioxyde de carbone et d'alcool.

8. Procédé de gravure de la jonction de tunnel magnétique MRAM selon la revendication 1 ou la revendication 2, dans lequel, à l'étape de gravure principale et à l'étape de nettoyage, lors de l'adoption de la gravure ionique réactive, une puissance de la source d'ions dans la chambre d'ions de réaction est comprise entre 50 W et 1000 W, une pression de chambre est comprise entre 0,066661185 Pa (0,5 mTorr) et 1,3332237 Pa (10 mTorr), un débit de gaz est compris entre 10 sccm et 500 sccm, et le gaz est l'un ou une combinaison quelconque d'un gaz inerte, d'azote, d'oxygène, d'un gaz fluoré, d'un gaz traité aux amines, de monoxyde de carbone, de dioxyde de carbone et d'alcool.

9. Procédé de gravure de la jonction de tunnel magnétique MRAM selon la revendication 1, dans lequel une longueur d'un bord inférieur bas de la tranchée est L1, une longueur d'un bord inférieur haut de la tranchée est L2, une hauteur de la tranchée est H1, un angle inclus entre le bord inférieur bas et un bord latéral de la tranchée est α, L1:L2 = 0,3 à 1,0, H1:L2 = 0,1 à 2,0 et α = 90° à 130°.

10. Procédé de gravure de la jonction de tunnel magnétique MRAM selon la revendication 1, dans lequel le procédé comprend les étapes suivantes :
étape 1, l'étape de gravure principale de la jonction de tunnel magnétique consistant à :
effectuer la gravure d'étape de gravure principale avec la quantité de gravure de t1 = 35 nm sur la jonction de tunnel magnétique au moyen de la gravure par faisceau d'ions, dans lequel un procédé de la gravure par faisceau d'ions consiste à introduire un échantillon de jonction de tunnel magnétique dans une chambre de gravure par faisceau d'ions, dans lequel l'angle de direction du faisceau d'ions est choisi comme étant de 25°, une énergie du faisceau d'ions est de 600 V, et un gaz de protection est choisi comme étant de l'argon ;
l'échantillon de jonction de tunnel magnétique comprend une couche de masque, une couche de recouvrement, une jonction de tunnel magnétique, une couche métallique d'électrode inférieure et une couche diélectrique inférieure de haut en bas ; la couche diélectrique inférieure comporte une imbrication équidistante d'électrodes métalliques inférieures avec un même nombre de masques dans la couche de masque, et des positions des électrodes métalliques inférieures correspondent à des positions des masques ; et
la gravure par faisceau d'ions est interrompue à 5 nm restant de la couche métallique d'électrode inférieure ;
étape 2, l'étape de nettoyage de la jonction de tunnel magnétique consistant à :
effectuer la gravure d'étape de nettoyage avec la quantité de gravure de t2 = 30 nm sur la jonction de tunnel magnétique après l'exécution de l'étape de gravure principale au moyen de la gravure ionique réactive, dans lequel un procédé de la gravure ionique réactive consiste à transférer l'échantillon de jonction de tunnel magnétique après l'exécution de la gravure par faisceau d'ions de l'étape 1 de la chambre de gravure par faisceau d'ions en passant par une chambre de transfert sous vide vers une chambre de gravure ionique réactive pour effectuer la gravure ionique réactive, dans lequel des paramètres de la gravure ionique réactive sont tels que :
un rapport cyclique des impulsions d'ions réactifs est choisi comme étant de 20 %, une puissance de la source d'ions est de 700 W, une tension de polarisation est de 400 V, une pression de chambre est de 0,66661185 Pa (5 mTorr), et un débit d'argon est de 100 sccm ; et
étape 3, une protection in-situ de la jonction de tunnel magnétique consistant à : introduire l'échantillon de jonction de tunnel magnétique après l'exécution de la gravure d'étape de nettoyage en passant par une chambre de transfert sous vide dans une chambre de dépôt chimique en phase vapeur assisté par plasma, et déposer un film de SiN de 35 nm d'épaisseur à des fins de la protection in-situ.
